# EUROPÄISCHE PATENTSCHRIFT

(11) **EP 3 326 436 B1**
(45) Veröffentlichungstag und Bekanntmachung des Hinweises auf die Patenterteilung: **06.09.2023**
(21) Anmeldenummer: 16744694.7
(22) Anmeldetag: 21.07.2016
(51) Int. Cl.: H05H 1/24

(54) **ELEKTRODENANORDNUNG UND PLASMAQUELLE ZUR ERZEUGUNG EINES NICHT-THERMISCHEN PLASMAS SOWIE EIN VERFAHREN ZUM BETREIBEN EINER PLASMAQUELLE**
ELECTRODE ASSEMBLY AND PLASMA SOURCE FOR GENERATING A NON-THERMAL PLASMA, AND METHOD FOR OPERATING A PLASMA SOURCE
ENSEMBLE D'ÉLECTRODES ET SOURCE DE PLASMA POUR GÉNÉRER UN PLASMA NON THERMIQUE AINSI QUE PROCÉDÉ DE FONCTIONNEMENT D'UNE SOURCE DE PLASMA

(30) Priorität: 23.07.2015 DE 102015213975
(43) Veröffentlichungstag der Anmeldung: 30.05.2018
(73) Patentinhaber: Terraplasma GmbH, 85748 Garching (DE)
(72) Erfinder: MORFILL, Gregor, 81927 München (DE); SHIMIZU, Tetsuji, Ibaraki 305-0044 (JP); LI, Yangfang, 82140 Olching (DE)
(74) Vertreter: Kordel, Mattias
(86) Internationale Anmeldenummer: PCT/EP2016/067418
(87) Internationale Veröffentlichungsnummer: WO 2017/013211

(56) Entgegenhaltungen:
- EP-A1- 0 537 613
- EP-A1- 2 322 272
- WO-A2-2009/015371
- WO-A2-2011/133807
- DE-C1- 10 108 717
- US-A- 4 783 716
- US-A1- 2009 121 127

## Beschreibung

Die Erfindung betrifft eine Elektrodenanordnung und eine Plasmaquelle zur Erzeugung eines nicht-thermischen Plasmas, sowie ein Verfahren zum Betreiben einer Plasmaquelle.

Elektrodenanordnungen zur Erzeugung eines nicht-thermischen Plasmas weisen typischerweise eine erste Elektrode und eine zweite Elektrode auf, wobei die Elektroden durch ein dielektrisches Element elektrisch voneinander isoliert und räumlich zueinander beabstandet sind. Typische Einsatzbereiche für solche Elektrodenanordnungen beziehungsweise der durch solche Elektrodenanordnungen erzeugten, nicht-thermischen Plasmen finden sich im Bereich der Desinfektion oder Sterilisation, der Oberflächenfunktionalisierung, und auch im medizinischen Bereich, insbesondere zur Wunddesinfektion, Wundbehandlung und Wundheilung, zur Behandlung von Hautirritationen, sowie zur Behandlung bakterieller, viraler und von Pilzen verursachter Hauterkrankungen. Es zeigt sich, dass eine chemische Zusammensetzung des von der Elektrodenanordnung erzeugten Plasmas stark von einem Abstand abhängt, der senkrecht zu einer aktiven Oberfläche der Elektrodenanordnung gemessen wird, wie dies in der internationalen Patentanmeldung mit der Veröffentlichungsnummer WO 2012/150041 A1 sowie in der US-Patentanmeldung US 2014/0207053 A1 beschrieben ist. Je nach konkreter Anwendung ist dabei eine verschiedene chemische Zusammensetzung und somit auch ein verschiedener Behandlungsabstand einer zu behandelnden Oberfläche von der aktiven Oberfläche der Elektrodenanordnung wünschenswert. Ein relevanter Abstandsbereich zur Einstellung der Plasmachemie beträgt beispielsweise zwischen 2 und 4 mm. Herkömmliche Elektrodenanordnungen sind jedoch nur mit vergleichsweise hohen Spannungsamplituden effizient betreibbar, sodass sie aus Gründen der elektrischen Sicherheit kaum oder nur unter erheblichem Zusatzaufwand nahe genug an zu behandelnde Oberflächen - beispielsweise die Haut eines Patienten - heran verlagert werden können, sodass die Plasmachemie kaum in gewünschter und flexibler Weise eingestellt werden kann. Darüber hinaus sind herkömmliche Elektrodenanordnungen vergleichsweise groß und insbesondere starr ausgebildet, was einer Miniaturisierung von Vorrichtungen, welche eine solche Elektrodenanordnung aufweisen, sowie einem geometrisch flexiblen Einsatz der Elektrodenanordnung im Weg steht. Weitere Ausführungen von nicht-thermischen Plasmavorrichtungen sind aus US 2009/121127 A1, EP 0 537 613 A1, US 4 783 716 A und DE 101 08 717 C1 bekannt.

Der Erfindung liegt die Aufgabe zugrunde, eine Elektrodenanordnung sowie eine Plasmaquelle zur Erzeugung eines nicht-thermischen Plasmas und ein Verfahren zum Betreiben einer Plasmaquelle zu schaffen, wobei die genannten Nachteile nicht auftreten.

Die Aufgabe wird gelöst, indem die Gegenstände der unabhängigen Ansprüche geschaffen werden. Vorteilhafte Ausgestaltungen ergeben sich aus den Unteransprüchen.

Die Aufgabe wird insbesondere gelöst, indem eine Elektrodenanordnung zur Erzeugung eines nicht-thermischen Plasmas geschaffen wird, welche eine erste Elektrode und eine zweite Elektrode aufweist, wobei die erste Elektrode und die zweite Elektrode voneinander durch ein dielektrisches Element elektrisch isoliert und durch das dielektrische Element - insbesondere durchgehend, das heißt insbesondere ohne Unterbrechung entlang ihrer gesamten Erstreckung - räumlich zueinander beabstandet sind. Die Elektrodenanordnung zeichnet sich dadurch aus, dass die erste Elektrode - in Richtung der Beabstandung der Elektroden voneinander gesehen - eine Dicke von mindestens 10 µm aufweist, wobei die zweite Elektrode - ebenfalls in Richtung der Beabstandung der Elektroden voneinander gesehen - eine Dicke von mindestens 1 µm bis höchstens 5 µm, oder eine Dicke von mindestens 5 µm bis höchstens 30 µm aufweist. Dabei ist vorgesehen, dass das dielektrische Element - in Richtung der Beabstandung der Elektroden voneinander gesehen - eine Dicke von mindestens 10 µm bis höchstens 250 µm aufweist. Weiter ist die erste Elektrode als Blatt- oder Schichtelektrode ohne Ausnehmung ausgebildet ist und die zweite Elektrode mit mindestens einer Ausnehmung ausgebildet Aufgrund der sehr dünnen Ausgestaltung der Elektroden und des dielektrischen Elements ist es möglich, eine kleinere und insbesondere dünnere Elektrodenanordnung als bisher bekannt zu schaffen, welche geeignet ist, bei Spannungsamplituden betrieben zu werden, die einen deutlich reduzierten Sicherheitsabstand zu einer behandelten Oberfläche erlauben. Somit ist es möglich, die Plasmachemie flexibel auf die gewünschte Anwendung abzustimmen und insbesondere in Abstandsbereiche vorzudringen, die bisher aus Gründen der elektrischen Sicherheit nicht darstellbar waren. So kann bevorzugt für jede gewünschte Anwendung eine passende Plasmachemie ausgewählt und ein entsprechender Abstand zu einer behandelten Oberfläche sichergestellt werden. Weiterhin ist die Elektrodenanordnung aufgrund der sehr dünn gewählten Elektroden und dem ebenfalls sehr dünn gewählten dielektrischen Element als Dünnschicht-Elektrodenanordnung ausgebildet und so insgesamt biegsam und/oder flexibel, sodass eine Miniaturisierung einer Vorrichtung, welche die Elektrodenanordnung aufweist, möglich wird, und wobei die Elektrodenanordnung selbst geometrisch äußerst flexibel einsetzbar und insbesondere auf eine geometrische Form einer zu behandelnden Oberfläche abgestimmt werden kann. Hierzu bedarf es keiner spezifischen Formung der Elektroden und/oder des dielektrischen Elements bei der Herstellung, vielmehr kann die Elektrodenanordnung insgesamt aufgrund ihrer biegsamen Eigenschaft einfach auf die Geometrie der zu behandelnden Oberfläche angepasst werden, insbesondere durch Biegen.

Vorzugsweise weist die zweite Elektrode eine Dicke von mindestens 5 µm bis höchstens 30 µm auf.

Vorzugsweise weist die zweite Elektrode eine Dicke von mindestens 1 µm bis höchstens 5 µm auf.

Die Elektrodenanordnung ist insbesondere eingerichtet zur Erzeugung von Oberflächen-Mikroentladungen.

Wird an die beiden Elektroden eine Potentialdifferenz, insbesondere eine Wechselspannung, angelegt, bilden sich an einer aktiven Oberfläche der Elektrodenanordnung Oberflächen-Mikroentladungen aus, die wiederum zur Entstehung eines nicht-thermischen Plasmas im Bereich der aktiven Oberfläche führen.

Die erste Elektrode und die zweite Elektrode sind hierfür insbesondere als Leistungselektroden ausgebildet.

Die erste Elektrode und die zweite Elektrode sind übereinander, das heißt insbesondere auf zwei zueinander versetzten Ebenen, angeordnet und durch das dielektrische Element voneinander beabstandet - insbesondere in Form eines sandwichartigen Stapels. Dadurch ist beim Anlegen einer Potentialdifferenz zwischen den beiden Elektroden ein elektrisches Feld durch eine Spannung senkrecht zu einer Oberfläche des Dielektrikums erzeugbar.

Eine Obergrenze für die Dicke der ersten Elektrode wird bevorzugt so gewählt, dass die Elektrodenanordnung insgesamt biegsam und flexibel ist. Insbesondere wird bevorzugt für die Dicke der ersten Elektrode eine Obergrenze von höchstens 250 µm, vorzugsweise von höchstens 30 µm gewählt.

Die Untergrenze für die Dicke der ersten Elektrode ist bevorzugt so gewählt, dass resistive Verluste minimiert werden.

Es zeigt sich also, dass die Elektrodenanordnung vorzugsweise biegsam, insbesondere flexibel, ausgebildet ist.

Das dielektrische Element ist insbesondere zwischen der ersten Elektrode und der zweiten Elektrode angeordnet, sodass die Elektroden durch das dielektrische Element einerseits geometrisch voneinander beabstandet und andererseits elektrisch voneinander isoliert sind. Dabei ist die Anordnung insbesondere so gewählt, dass die erste Elektrode physischen Kontakt zu dem dielektrischen Element hat, wobei kein Luftspalt zwischen der ersten Elektrode und dem dielektrischen Element vorgesehen ist, wobei die zweite Elektrode physischen Kontakt zu dem dielektrischen Element hat, wobei kein Luftspalt zwischen der zweiten Elektrode und dem dielektrischen Element vorgesehen ist.

Die erste Elektrode, das dielektrische Element und die zweite Elektrode bilden derart vorzugsweise einen Stapel, wobei die Richtung der Beabstandung der Elektroden voneinander durch das dielektrische Element einer Stapelrichtung entspricht. Entsprechend werden die zuvor genannten Dicken in Stapelrichtung gemessen.

Unter einem nicht-thermischen Plasma wird insbesondere ein Plasma verstanden, bei welchem eine die Verteilung der kinetischen Energie der Elektronen des Plasmas beschreibende Temperatur, die auch als Elektronen-Temperatur bezeichnet wird, nicht identisch und insbesondere sehr viel höher ist als eine die Verteilung der kinetischen Energie der von dem Plasma umfassten Ionen, insbesondere Atomionen oder Molekülionen, beschreibende Temperatur, die auch als Ionen-Temperatur bezeichnet wird. Dabei ist die Elektronen-Temperatur sehr viel höher als die Ionen-Temperatur, wobei die lonen-Temperatur insbesondere im Bereich von 25 °C bis höchstens 100 °C gewählt werden kann. Ein solches Plasma wird aufgrund der vergleichsweise niedrigen Ionen-Temperatur auch als kaltes Plasma bezeichnet.

Als Plasma wird hier insbesondere ein Materiezustand bezeichnet, bei dem geladene Teilchen mit verschiedennamigen Ladungen in Gasphase nebeneinander vorliegen, wobei sich über ein bestimmtes Volumen gemittelt eine neutrale elektrische Ladung für das betrachtete Volumen ergibt. Das Plasma umfasst außerdem vorzugsweise nichtgeladene Atome und/oder Moleküle, die sich in elektronisch, vibratorisch oder rotatorisch angeregten Zuständen befinden, und die auch als angeregte Teilchen bezeichnet werden, und/oder freie Radikale, insgesamt also insbesondere nichtgeladene reaktive Atome und/oder Moleküle, die auch als reaktive Teilchen oder reaktive Spezies bezeichnet werden. Die chemische Zusammensetzung des Plasmas ändert sich dabei insbesondere abhängig von einem Abstand, der senkrecht zu einer aktiven Oberfläche der Elektrodenanordnung gemessen wird, an welcher das Plasma gebildet wird.

Es wird ein Ausführungsbeispiel der Elektrodenanordnung bevorzugt, das sich dadurch auszeichnet, dass die zweite Elektrode auf einer dem dielektrischen Element abgewandten Seite ein dielektrisches Deckelement aufweist, das - in Stapelrichtung gesehen - eine Dicke von mindestens 0.2 µm bis höchstens 30 µm aufweist. Das dielektrische Deckelement dient einem Schutz der zweiten Elektrode vor Beschädigung, insbesondere vor chemischer oder mechanischer Erosion, und verhindert zugleich einen direkten Kontakt einer behandelten Oberfläche mit der zweiten Elektrode. Durch die sehr dünne Ausgestaltung des dielektrischen Deckelements ist die Elektrodenanordnung biegsam, insbesondere flexibel, auch wenn sie das dielektrische Deckelement aufweist.

Bei einem bevorzugten Ausführungsbeispiel ist das dielektrische Deckelement als Beschichtung ausgebildet, wobei insbesondere die zweite Elektrode mit dem dielektrischen Deckelement beschichtet ist. Die Elektrodenanordnung ist vorzugsweise so eingerichtet, dass das nicht-thermische Plasma - von dem dielektrischen Element aus gesehen - auf der Seite der zweiten Elektrode erzeugt wird, insbesondere an einer Oberfläche der zweiten Elektrode, oder an einer der zweiten Elektrode abgewandten Oberfläche des dielektrischen Deckelements.

Das dielektrische Deckelement dient insbesondere als Schutzbeschichtung, insbesondere zur Gewährleistung der elektrischen Sicherheit der Elektrodenanordnung für eine Bedienperson und/oder für mit dem nicht-thermischen Plasma behandelte Teile.

Es hat sich gezeigt, dass insbesondere unter dem Aspekt der elektrischen Sicherheit das Verhältnis der Dicke des dielektrischen Elements zu der Dicke des dielektrischen Deckelements bevorzugt von mindestens 5 bis höchstens 15, vorzugsweise von mindestens 8 bis höchstens 12, vorzugsweise 10 beträgt.

Es wird ein Ausführungsbeispiel der Elektrodenanordnung bevorzugt, das sich dadurch auszeichnet, dass die erste Elektrode auf einer dem dielektrischen Element abgewandten Seite ein dielektrisches Bodenelement aufweist. Mithilfe des dielektrischen Bodenelements ist es bevorzugt möglich, von der ersten Elektrode ausgehende Koronaentladungen zu verhindern oder zu unterdrücken, welche andernfalls eine Effizienz der Elektrodenanordnung reduzieren würden. Eine - in Stapelrichtung gemessene - Dicke des dielektrischen Bodenelements ist vorzugsweise einerseits so gewählt, dass Koronaentladungen, welche von der ersten Elektrode ausgehen, wirksam und effizient, vorzugsweise vollständig, unterdrückt werden, wobei andererseits die Elektrodenanordnung insgesamt biegsam, insbesondere flexibel, bleibt. Insbesondere ist es möglich, dass das dielektrische Bodenelement eine Dicke von mindestens 10 µm bis höchstens 250 µm, vorzugsweise höchstens 30 µm aufweist.

Das dielektrische Bodenelement ist vorzugsweise flächig ausgebildet und erstreckt sich besonders bevorzugt entlang einer gesamten Erstreckung der ersten Elektrode. Bei einem bevorzugten Ausführungsbeispiel ist das dielektrische Bodenelement als Beschichtung ausgebildet, wobei die erste Elektrode insbesondere mit auf ihrer dem dielektrischen Element abgewandten Seite mit dem dielektrischen Bodenelement beschichtet ist.

Es wird ein Ausführungsbeispiel der Elektrodenanordnung bevorzugt, das sich dadurch auszeichnet, dass wenigstens eine Elektrode, ausgewählt aus der ersten Elektrode und der zweiten Elektrode, ein Material aufweist oder aus einem Material besteht, welches ausgewählt ist aus einer Gruppe bestehend aus Kupfer, Silber, Gold, und Aluminium. Auch andere leitfähige Materialien, insbesondere Metalle oder Halbmetalle, können zur Herstellung der wenigstens einen Elektrode verwendet werden. Auch ist es möglich, wenigstens eine der ersten und zweiten Elektrode aus einer Metalllegierung, insbesondere einer Legierung, die wenigstens eines der zuvor genannten Elemente aufweist, herzustellen. Wichtig ist, dass die Elektroden aus einem leitfähigen Material, vorzugsweise mit möglichst kleinem elektrischen Widerstand, gefertigt sind.

Es wird auch ein Ausführungsbeispiel der Elektrodenanordnung bevorzugt, das sich dadurch auszeichnet, dass wenigstens ein Element, ausgewählt aus dem dielektrischen Element, dem dielektrischen Deckelement und dem dielektrischen Bodenelement, ein Material aufweist oder aus einem Material besteht, wobei das Material ausgewählt ist aus einer Gruppe bestehend aus Siliziumnitrid (SiN), einem Silikat, insbesondere Quarz (SiO₂), einem Glas, und einem Kunststoff, insbesondere Polyamid. Auch andere anorganische oder organische Materialien sind für das Element möglich. Wichtig ist, dass das gewählte Material dielektrische Eigenschaften aufweist und insbesondere nicht-leitend, insbesondere als elektrischer Isolator, ausgebildet ist.

Bei der erfindungsgemäßen Elektrodenanordnung ist die erste Elektrode flächig ausgebildet und als Schichtelektrode oder als Blattelektrode ohne Ausnehmung ausgebildet. Dies ermöglicht eine homogene Verteilung des erzeugten Plasmas und insbesondere eine homogene Leistungsverteilung für dieses.

Bei einem Ausführungsbeispiel, das nicht Teil der Erfindung ist, ist vorgesehen, dass die zweite Elektrode strukturiert ausgebildet ist. Dabei kann die zweite Elektrode insbesondere auf konkrete Anforderungen an die Elektrodenanordnung, insbesondere auf einen konkreten Einsatz der Elektrodenanordnung, in ihrer geometrischen Struktur abgestimmt werden.

Bei einem Ausführungsbeispiel, das nicht Teil der Erfindung ist, der Elektrodenanordnung ist vorgesehen, dass die zweite Elektrode eine kammartige Struktur aufweist. Dies bezeichnet insbesondere eine Struktur, bei welcher die zweite Elektrode ein langgestrecktes Basiselement aufweist, von dem ausgehend sich parallel zueinander orientierte Elektrodenäste erstrecken, die mit dem Basiselement elektrisch verbunden sind. Es ist auch möglich, dass die zweite Elektrode eine linienförmige Struktur aufweist, wobei die Linienstruktur wenigstens eine gerade Linie aufweist. Vorzugsweise weist die linienförmige Struktur eine Mehrzahl insbesondere parallel zueinander angeordneter, und elektrisch miteinander verbundener gerader Linien auf. Dabei kann insbesondere eine kammartige Struktur mit einem Basiselement vorgesehen sein, wobei von dem Basiselement ausgehend und mit dem Basiselement elektrisch verbunden sich parallel zueinander angeordnete, linienförmige Elektrodenäste erstrecken.

Bei einem Ausführungsbeispiel, das nicht Teil der Erfindung ist, ist es auch möglich, dass die zweite Elektrode eine gewundene Struktur aufweist, insbesondere eine Schlangenlinienstruktur. Insbesondere ist es möglich, dass die zweite Elektrode als eine Schlangenlinie ausgebildet ist. Vorzugsweise kann auch vorgesehen sein, dass die zweite Elektrode eine Mehrzahl von - parallel zueinander angeordneten - Schlangenlinien aufweist, die miteinander elektrisch verbunden sind. Insbesondere ist auch eine kammartige Struktur möglich, bei welcher ausgehend von einem Basiselement sich elektrisch mit dem Basiselement verbundene - vorzugsweise parallel zueinander orientierte - Elektrodenäste in Form von Schlangenlinien erstrecken.

Bei einem Ausführungsbeispiel, das nicht Teil der Erfindung ist, ist es auch möglich, dass die zweite Elektrode eine Spiralstruktur aufweist, insbesondere in Form einer Kreisspirale oder einer eckigen Spirale, oder dass die zweite Elektrode eine Mäanderstruktur aufweist.

Weist die zweite Elektrode eine Linie oder eine Mehrzahl von Linien auf, beispielsweise in Form einer Schlangenlinie oder einer geraden Linie, oder in Form einer spiral- oder mäanderförmig verlaufenden Linie, weist eine solche Linie der zweiten Elektrode vorzugsweise eine Breite von mindestens 50 µm bis höchstens 200 µm auf. Eine solche Breite hat sich als besonders günstig einerseits in Hinblick auf die elektrischen Eigenschaften der Elektrodenanordnung sowie die Eigenschaften des erzeugten Plasmas und andererseits in Hinblick auf die Biegsamkeit und Flexibilität der Elektrodenanordnung erwiesen.

Bei der erfindungsgemäßen Ausführung ist vorgesehen, dass die zweite Elektrode eine flächige Struktur mit wenigstens einer Ausnehmung aufweist. Dies bedeutet insbesondere, dass die zweite Elektrode flächig ausgebildet ist, wobei sie wenigstens eine Ausnehmung, vorzugsweise wenigstens einen Durchbruch, insbesondere in ihrer Fläche aufweist. In diesem Fall können Oberflächen-Mikroentladungen insbesondere in der wenigstens einen Ausnehmung erzeugt werden. Die Oberflächen-Mikroentladungen werden insbesondere an Kanten der wenigstens einen Ausnehmung erzeugt.

Es hat sich herausgestellt, dass Kanten der wenigstens einen Ausnehmung vorzugsweise einen Abstand zueinander aufweisen, der mindestens 0,5 mm, vorzugsweise mehr als 0,5 mm beträgt. Insbesondere hat die wenigstens eine Ausnehmung vorzugsweise eine Breite von wenigstens 0,5 mm, vorzugsweise von mehr als 0,5 mm.

Numerische Simulationen der Elektrodenanordnung haben gezeigt, dass das elektrische Feld an den Kanten einer solchen Ausnehmung der zweiten Elektrode eine Ausdehnung von ungefähr 30 µm bis 50 µm hat. An zwei einander gegenüberliegenden Kanten einer solchen Ausnehmung können Mikroentladungen daher in zwei Bereichen mit einer Ausdehnung senkrecht zur Kante von ungefähr jeweils 30 µm bis 50 µm entstehen. Um eine Interferenz und Schwächung des elektrischen Felds und damit auch der Entladungen zu vermeiden, muss daher ein Abstand der Kanten sehr viel größer gewählt werden als die doppelte Ausdehnung der einzelnen Mikroentladungen, mithin größer als 60 µm bis 100 µm. Es hat sich herausgestellt, dass ein Abstand der Kanten der Ausnehmung voneinander von mindestens 500 µm, vorzugsweise von mehr als 500 µm, also 0,5 mm, ausreichend ist, um ungeschwächte Oberflächen-Mikroentladungen mit hohem Wirkungsgrad bereitzustellen.

Die wenigstens eine Ausnehmung ist vorzugsweise nach Art einer eingravierten Struktur in der zweiten Elektrode ausgebildet.

Vorzugsweise bildet die wenigstens eine Ausnehmung ein dem menschlichen Verstand zugängliches oder durch den menschlichen Verstand erkennbares Zeichen, beispielsweise ein Piktogramm, ein Symbol, wenigstens einen Buchstaben, eine Zahl oder ein Wort, beispielsweise einen Namen, oder ein Bild, beispielsweise ein Gesicht, ein Objekt, ein Logo, oder dergleichen. Dabei ist es möglich, dass die zweite Elektrode eine Mehrzahl von Ausnehmungen aufweist, die verschiedene dem menschlichen Verstand zugängliche Symbole, oder aber gemeinsam ein dem menschlichen Verstand zugängliches Symbol bilden können.

Gemäß einer Weiterbildung der Erfindung ist vorgesehen, dass die erste Elektrode - senkrecht zur Stapelrichtung - zumindest bereichsweise, vorzugsweise vollständig, über eine Umrandung der zweiten Elektrode übersteht. In diesem Fall können Oberflächen-Mikroentladungen auch an einem äußeren Rand, das heißt einer äußeren Umfangslinie oder -kante der zweiten Elektrode erzeugt werden.

Alternativ oder zusätzlich ist es möglich, dass die erste Elektrode - senkrecht zur Stapelrichtung gesehen - zumindest bereichsweise eine geringere Ausdehnung aufweist als die zweite Elektrode, sodass die zweite Elektrode in dieser Richtung zumindest bereichsweise, vorzugsweise vollständig, über die erste Elektrode vorsteht. In diesem Fall können jedenfalls dort, wo die zweite Elektrode seitlich, das heißt senkrecht zur Stapelrichtung, über die erste Elektrode vorsteht, keine Mikroentladungen an der Umfangskante der zweiten Elektrode erzeugt werden.

Das dielektrische Element erstreckt sich bevorzugt - senkrecht zur Stapelrichtung gesehen - über äußere Umfangslinien beider Elektroden, das heißt der ersten Elektrode und der zweiten Elektrode, hinaus.

Es ist im Übrigen möglich, dass die zweite Elektrode auf dem dielektrischen Element angeordnet, insbesondere auf diesem abgeschieden ist, beispielsweise durch physikalische Dampfabscheidung oder dergleichen. Es ist aber auch möglich, dass die zweite Elektrode in das dielektrische Element eingebettet ist.

Bei einem bevorzugten Ausführungsbeispiel der Elektrodenanordnung ist vorgesehen, dass das dielektrische Element flächig ausgebildet ist. Insbesondere ist es möglich, dass das dielektrische Element als Beschichtung der ersten Elektrode ausgebildet ist, wobei die zweite Elektrode vorzugsweise auf dem dielektrischen Element aufgebaut oder als - gegebenenfalls lokale - Beschichtung des dielektrischen Elements hergestellt ist.

Alternativ oder zusätzlich ist bevorzugt das dielektrische Deckelement flächig ausgebildet, wobei es bevorzugt die zweite Elektrode vollständig einhaust oder einkapselt und so vor einem Kontakt mit einer behandelten Fläche sowie vor einer Beschädigung, insbesondere einer chemischen oder mechanischen Erosion, schützt.

Alternativ oder zusätzlich ist das dielektrische Bodenelement vorzugsweise flächig ausgebildet und schützt so insbesondere eine der zweiten Elektrode abgewandte Seite der ersten Elektrode vor äußeren Einwirkungen.

Es wird ein Ausführungsbeispiel der Elektrodenanordnung bevorzugt, das sich dadurch auszeichnet, das wenigstens ein Element, ausgewählt aus dem dielektrischen Element, dem dielektrischen Deckelement, und dem dielektrischen Bodenelement, eine mittlere Oberflächenrauheit Rₐ aufweist, die geringer ist als 5 % der Dicke des Elements. Besonders bevorzugt wird eine solche Oberflächenrauheit Rₐ für das dielektrische Element und/oder das dielektrische Deckelement. Durch die sehr geringe Oberflächenrauheit von wenigstens einem dieser Elemente kann eine möglichst homogene und gleichmäßige Leistungsverteilung des mittels der Elektrodenanordnung erzeugten, nicht-thermischen Plasmas gewährleistet werden. Insbesondere werden lokale Leistungsspitzen und Leistungsminima weitestgehend vermieden.

Unter einer mittleren Oberflächenrauheit wird hier insbesondere ein mittlerer Abstand eines gedachten Messpunkts - auf der betrachteten Oberfläche - zu einer gedachten Mittellinie der betrachteten Oberfläche bezeichnet. Dabei schneidet die gedachte Mittellinie innerhalb einer Bezugsstrecke das Oberflächenprofil so, dass eine Summe der Profilabweichungen - bezogen auf die gedachte Mittellinie - minimal wird. Somit entspricht die mittlere Rauheit Rₐ dem arithmetischen Mittel einer betragsmäßigen Abweichung von der gedachten Mittellinie.

Die mittlere Rauheit Rₐ wird vorzugsweise mit einer optischen Methode gemessen. Besonders bevorzugt wird die mittlere Rauheit mittels eines Verfahrens bestimmt, wie es in der Norm ISO 25178 - in der zu dem den Zeitrang der vorliegenden Anmeldung bestimmenden Tag gültigen Fassung - definiert ist. Zur Bestimmung der mittleren Rauheit kann ein Konfokalverfahren, eine konoskopische Holographie, eine Weißlichtinterferometrie und/oder eine Fokusvariation angewendet werden. Auch ein Luftstromverfahren ist möglich, beispielsweise zur Bestimmung einer Glätte nach Bekk, einer Glätte nach Parker Print Surf oder einer Glätte nach Bendtsen. Bevorzugt ergibt sich gemäß jedem der hier genannten Messverfahren für das betrachtete Element eine mittlere Oberflächenrauheit Rₐ, die geringer ist als 5 % der Dicke des betrachteten Elements.

Zusätzlich oder alternativ ist bevorzugt vorgesehen, dass eine Dicken-Variation von wenigstens einem Element ausgewählt aus dem dielektrischen Element, dem dielektrischen Deckelement und dem dielektrischen Bodenelement, geringer ist als 5 % der Dicke des betrachteten Elements. Dies wird besonders bevorzugt für das dielektrische Element und/oder das dielektrische Deckelement. Auch hierdurch ergibt sich eine verbesserte Homogenität der Leistungsverteilung des erzeugten Plasmas.

Die Aufgabe wird auch gelöst, indem eine Plasmaquelle zur Erzeugung eines nicht-thermischen Plasmas geschaffen wird, welche eine Spannungsquelle und eine Elektrodenanordnung nach einem der zuvor beschriebenen Ausführungsbeispiele aufweist. Dabei ist die Spannungsquelle mit zumindest der ersten Elektrode elektrisch verbunden. In Zusammenhang mit der Plasmaquelle ergeben sich insbesondere die Vorteile, die bereits in Zusammenhang mit der Elektrodenanordnung erläutert wurden.

Dass die Spannungsquelle zumindest mit der ersten Elektrode elektrisch verbunden ist, bedeutet insbesondere, dass an die erste Elektrode eine elektrische Spannung oder ein elektrisches Signal, insbesondere eine Wechselspannung, angelegt wird.

Bevorzugt ist vorgesehen, dass die zweite Elektrode auf Masse gelegt oder geerdet ist. Dies erhöht die elektrische Sicherheit der Plasmaquelle, da die zweite Elektrode näher an einer zu behandelnden Oberfläche angeordnet ist, als die erste Elektrode. Kommt es beispielsweise beim Biegen der flexiblen Elektrodenanordnung zu einem Bruch und zu einem Austritt eines Teils der zweiten Elektrode aus dem dielektrischen Deckelement, besteht keine Gefahr in einer Berührung dieses Teils der zweiten Elektrode mit der behandelten Oberfläche, insbesondere mit der Haut eines Patienten, wenn die zweite Elektrode auf Masse liegt oder geerdet ist.

Bei einem bevorzugten Ausführungsbeispiel der Plasmaquelle ist vorgesehen, dass die Spannungsquelle auch mit der zweiten Elektrode elektrisch verbunden ist. Besonders bevorzugt ist die zweite Elektrode über die Spannungsquelle geerdet oder auf Masse gelegt.

Alternativ ist es auch möglich, dass die Spannungsquelle nur mit der ersten Elektrode elektrisch verbunden ist, wobei vorzugsweise die Spannungsquelle einerseits und die zweite Elektrode andererseits mit einem gemeinsamen Massepunkt oder einem gemeinsamen Erdpunkt verbunden sein können.

Es wird ein Ausführungsbeispiel der Plasmaquelle bevorzugt, das sich dadurch auszeichnet, dass die erste Elektrode mit einer Wechselspannung beaufschlagbar ist, wobei die zweite Elektrode auf Masse gelegt ist. Dies kann - wie bereits zuvor erläutert - vermittelt über die Spannungsquelle oder durch Kontaktierung der zweiten Elektrode mit einem Masse- oder Erdpunkt außerhalb der Spannungsquelle geschehen.

Es ist auch ein Ausführungsbeispiel der Plasmaquelle möglich, bei welchem die zweite Elektrode kein definiertes elektrisches Potential aufweist, mithin floatet.

Es wird auch ein Ausführungsbeispiel der Plasmaquelle bevorzugt, das sich dadurch auszeichnet, dass die Plasmaquelle, vorzugsweise die Spannungsquelle, eingerichtet ist zur Erzeugung einer Wechselspannung, welche eine Amplitude von mindestens 0,5 kV von Spitze zu Spitze, was auch als kVₚₚ bezeichnet wird, bis höchstens 3 kVₚₚ, vorzugsweise von mindestens 1,0 kVₚₚ bis höchstens 2,5 kVₚₚ, vorzugsweise von mindestens 1,0 kVₚₚ bis höchstens 2,0 kVₚₚ, vorzugsweise 1,5 kVₚₚ, und/oder eine Frequenz von mindestens 20 kHz bis höchstens 90 kHz, vorzugsweise von mindestens 30 kHz bis höchstens 80 kHz, vorzugsweise von mindestens 40 kHz bis höchstens 70 kHz, vorzugsweise von mindestens 50 kHz bis höchstens 60 kHz, vorzugsweise 50 kHz, aufweist. Durch die sehr dünne Ausgestaltung der Elektrodenanordnung ist es möglich, die erste Elektrode mit einer Wechselspannung zu beaufschlagen, welche eine vergleichsweise geringe Amplitude aufweist. Dies erhöht die elektrische Sicherheit der Plasmaquelle und minimiert einen einzuhaltenden Sicherheitsabstand einer zu behandelnden Oberfläche von der Oberfläche der Elektrodenanordnung, auf welcher das Plasma erzeugt wird. Somit ist es in flexiblerer Weise möglich, eine optimale Plasmachemie, mithin eine optimale chemische Zusammensetzung des erzeugten Plasmas, für eine bestimmte, gewünschte Behandlungsart der zu behandelnden Oberfläche einzustellen. Insbesondere wird es möglich, einen Behandlungsabstand von mindestens 2 mm bis höchstens 4 mm zu wählen.

Die sehr dünne, geometrische Ausgestaltung der Elektrodenanordnung ermöglicht es, zusätzlich oder alternativ eine Frequenz für die Wechselspannung zu wählen, die oberhalb einer höchsten Audiofrequenz, nämlich insbesondere oberhalb von 20 kHz, liegt. Hierzu trägt auch insbesondere bei, dass die erste Elektrode bevorzugt flächig oder als Schichtelektrode oder Blattelektrode ausgebildet ist, wodurch Streukapazitäten der Elektrodenanordnung minimiert werden. Die Wahl solcher höheren Frequenzen oberhalb einer höchsten Audiofrequenz erhöhen zum einen die elektrische Sicherheit der Plasmaquelle, zum anderen wird der Einsatz von Piezo-Verstärkern möglich, insbesondere wenn eine Frequenz von mindestens 50 kHz gewählt wird. Dies wiederum erlaubt eine weitergehende Miniaturisierung der Plasmaquelle, weil solche Piezo-Verstärker sehr klein ausgebildet sein können. Insbesondere kann ein solcher Piezo-Verstärker eine Dicke von ungefähr 2 mm, eine Breite von ungefähr 8 mm und eine Länge von ungefähr 50 mm aufweisen. Somit wird es möglich, eine Plasmaquelle bereitzustellen, die beispielsweise die Größe eines Bleistifts aufweist. Letztlich ist nicht mehr die Plasmaquelle selbst für die Größe einer Plasmaeinrichtung, welche die Plasmaquelle aufweist, limitierend, sondern vielmehr die Größe einer elektrischen Speichereinrichtung zur Versorgung der Spannungsquelle mit elektrischer Leistung, falls es sich um eine tragbare, netzunabhängige Vorrichtung handelt. Insbesondere ist die Größe eines Akkumulators limitierend für die mögliche Miniaturisierung der entsprechenden Vorrichtung.

Es wird insbesondere ein Ausführungsbeispiel der Plasmaquelle bevorzugt, das sich dadurch auszeichnet, dass Plasmaquelle, insbesondere die Spannungsquelle, einen Piezo-Verstärker aufweist. Dabei ergibt sich der bereits beschriebene Vorteil einer kleineren Bauweise und verbesserter Miniaturisierungsmöglichkeiten der Plasmaquelle.

Solche Piezo-Verstärker oder Piezo-Transformatoren sind optimal bei einer Frequenz von ungefähr 50 kHz betreibbar, da in diesem Bereich ihre Resonanzfrequenz liegt. Weiterhin werden sie optimal bei einer Spannung von höchstens 3 kVₚₚ betrieben. Beides ermöglicht die hier vorgeschlagene Elektrodenanordnung aufgrund ihrer geringen elektrischen Kapazität, wodurch ansonsten hohe Verluste vermieden werden, und aufgrund der Möglichkeit, sie mit vergleichsweise geringer Wechselspannungsamplitude zu betreiben.

Die Aufgabe wird schließlich auch gelöst, indem ein Verfahren zum Betreiben einer Plasmaquelle geschaffen wird, wobei im Rahmen des Verfahrens eine Elektrodenanordnung nach einem der zuvor beschriebenen Ausführungsbeispiele mittels einer Spannungsquelle mit elektrischer Spannung beaufschlagt wird, und/oder wobei eine Plasmaquelle nach einem der zuvor beschriebenen Ausführungsbeispiele betrieben wird. Dabei verwirklichen sich in Zusammenhang mit dem Verfahren insbesondere die Vorteile, die bereits in Zusammenhang mit der Elektrodenanordnung und/oder mit der Plasmaquelle erläutert wurden.

Insbesondere werden im Rahmen des Verfahren Oberflächen-Mikroentladungen erzeugt. Durch Variation der elektrischen Parameter der Plasmaquelle kann eine Plasmachemie des durch Oberflächen-Mikroentladungen erzeugten Plasmas verändert werden.

Es wird eine Ausführungsform des Verfahrens bevorzugt, die sich dadurch auszeichnet, dass eine Wechselspannung mit einer Amplitude von mindestens 0,5 kVₚₚ bis höchstens 3 kVₚₚ, vorzugsweise von mindestens 1,0 kVₚₚ bis höchstens 2,5 kVₚₚ, vorzugsweise von mindestens 1,0 kVₚₚ bis höchstens 2,0 kVₚₚ, vorzugsweise von 1,5 kVₚₚ erzeugt wird. Dabei ergibt sich insbesondere der Vorteil einer erhöhten elektrischen Sicherheit im Betrieb der Plasmaquelle sowie einer geeigneten Wahl eines Abstands der Plasmaquelle zu einer behandelten Oberfläche in sehr flexibler und auf die Anwendung abgestimmter Weise, um die Plasmachemie stets flexibel und geeignet einstellen zu können.

Es wird auch eine Ausführungsform des Verfahrens bevorzugt, bei welcher die Wechselspannung mit einer Frequenz von mindestens 20 kHz bis höchstens 90 kHz, vorzugsweise von mindestens 30 kHz bis höchstens 80 kHz, vorzugsweise von mindestens 40 kHz bis höchstens 70 kHz, vorzugsweise von mindestens 50 kHz bis höchstens 60 kHz, vorzugsweise mit 50 kHz, erzeugt wird. Dabei ergibt sich zum einen der Vorteil einer erhöhten elektrischen Sicherheit im Betrieb der Plasmaquelle, und andererseits der Vorteil, dass Piezo-Verstärker eingesetzt werden können, was wiederum eine Miniaturisierung der Plasmaquelle ermöglicht.

Zur Erfindung gehört auch eine Vorrichtung zur Plasmabehandlung eines Gegenstands, insbesondere einer Oberfläche, welcher eine Elektrodenanordnung und/oder eine Plasmaquelle nach einem der zuvor beschriebenen Ausführungsbeispiele aufweist.

Weiterhin gehört zur Erfindung eine Verwendung einer Elektrodenanordnung und/oder einer Plasmaquelle zur Oberflächenfunktionalisierung, insbesondere zur Erzielung einer besseren Adhäsion, einer besseren Bindung von Oberflächenbeschichtungen, beispielsweise Farbe oder Lacke; zur Anwendung im Hygienebereich, beispielsweise zur Desinfektion oder Sterilisation von Ausrüstung, insbesondere medizinischer Ausrüstung, zur Handdesinfektion oder Handsterilisation, zur Oberflächendesinfektion oder Oberflächensterilisation; und/oder zur Anwendung im medizinischen Bereich, beispielsweise zur Wunddesinfektion oder Wundheilung, zur Behandlung von Hautirritationen, zur Behandlung von bakteriellen oder viralen Krankheiten der Haut sowie von Pilzerkrankungen der Haut.

Die erste Elektrode und die zweite Elektrode sind vorzugsweise vollständig eingekapselt in nicht-leitendes und/oder dielektrisches Material, wodurch die Sicherheit der Elektrodenanordnung erhöht wird.

Insgesamt ergeben sich in Zusammenhang mit der Elektrodenanordnung, der Plasmaquelle und dem Verfahren auch folgende Vorteile:
Durch die sehr dünne Ausgestaltung der Elektrodenanordnung kann diese einfach gebogen werden, sodass ein flexibles Design bei der Herstellung von Vorrichtungen, welche die Elektrodenanordnung und/oder die Plasmaquelle aufweisen, möglich wird.

Es kann eine kleinere Spannungsquelle verwendet werden, weil ein größtes Teil in der Spannungsquelle letztlich ein Verstärker, insbesondere ein Transformator, ist, wobei eine Reduzierung der Größe des Verstärkers aufgrund der niedrigen Wechselspannung möglich ist.

Außerdem wird eine höhere Konversionseffizienz der Ausgangsleistung der Spannungsquelle zu der Arbeitsspannung, beispielsweise bei der Umwandlung einer Gleichspannung zu einer Wechselspannung, möglich, weil eine geringere Verstärkung nötig ist. Dies erlaubt wiederum eine weitergehende Miniaturisierung der Spannungsquelle und damit auch der Plasmaquelle.

Aufgrund der höheren elektrischen Sicherheit wird es möglich, die Dicke eines Isolatormaterials in einem Gehäuse der Elektronenanordnung oder der Plasmaquelle zu reduzieren, sodass kleinere Sicherheitsabstände möglich werden.

Die Variationsbreite von Abständen zwischen der Elektrodenanordnung und einer zu behandelnden Oberfläche wird erhöht. Somit kann die Zusammensetzung des Plasmas in Hinblick auf von dem Plasma umfasste reaktive Spezies an der zu behandelnden Oberfläche in verbesserter Weise kontrolliert und abhängig von der gewünschten Anwendung geeignet gewählt werden.

Im Falle eines Unfalls oder einer Störung wird das Risiko eines elektrischen Schocks für einen Betreiber der Elektrodenanordnung oder der Plasmaquelle und für eine behandelte Oberfläche, insbesondere die Haut eines Patienten, minimiert. Dabei ist der maximale elektrische Strom durch die angewendete Spannung bestimmt, die aufgrund der geometrischen Ausgestaltung der Elektronenanordnung reduziert werden kann.

Aufgrund der erhöhten elektrischen Sicherheit und der damit reduzierten Sicherheitsanforderungen sind insbesondere erhöhte Designfreiheiten in der Struktur der Elektrodenanordnung möglich.

Die Erfindung wird im Folgenden anhand der Zeichnung näher erläutert. Dabei zeigen:
- Figur 1: eine schematische Darstellung eines Ausführungsbeispiels einer Plasmaquelle;
- Figur 2: eine Mehrzahl verschiedener Ausführungsbeispiele, die nicht Teil der Erfindung sind, einer Elektrodenanordnung in Hinblick auf eine Struktur der zweiten Elektrode, und
- Figur 3: ein weiteres Ausführungsbeispiel einer Elektrodenanordnung insbesondere in Hinblick auf eine Struktur der zweiten Elektrode.

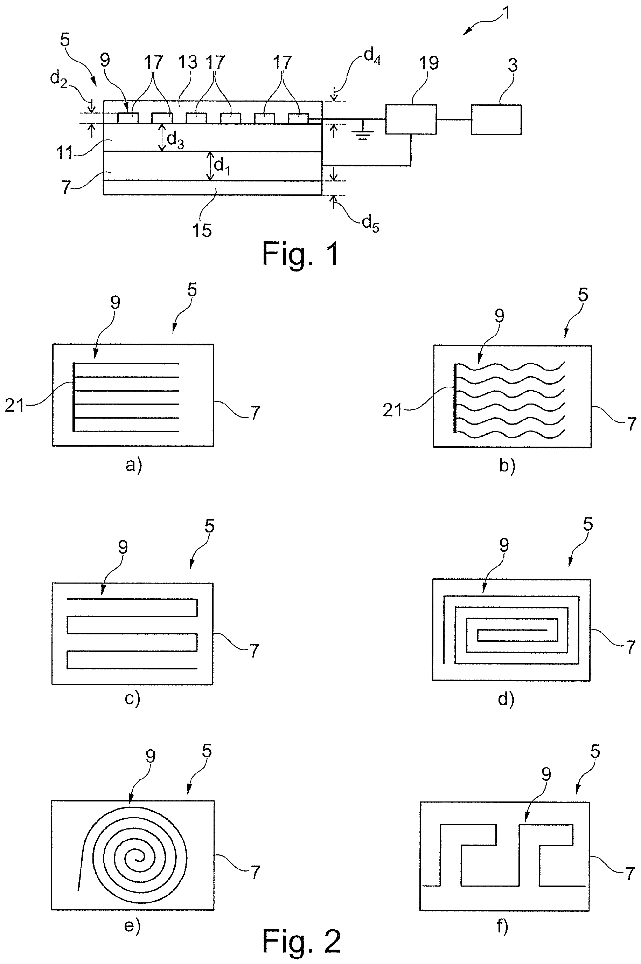

Figur 1 zeigt eine schematische Darstellung eines Ausführungsbeispiels einer Plasmaquelle 1, die eingerichtet ist zur Erzeugung eines nicht-thermischen Plasmas. Die Plasmaquelle 1 weist eine Spannungsquelle 3 auf, die mit einer Elektrodenanordnung 5 elektrisch verbunden ist. Die Elektrodenanordnung 5 ist ihrerseits eingerichtet zur Erzeugung eines nicht-thermischen Plasmas.

Sie weist eine erste Elektrode 7 und eine zweite Elektrode 9 auf, wobei zwischen der ersten Elektrode 7 und der zweiten Elektrode 9 ein dielektrisches Element 11 angeordnet ist, sodass die beiden Elektroden 7, 9 durch das dielektrische Element 11 elektrisch voneinander isoliert und zueinander beabstandet sind. Dabei bilden die beiden Elektroden 7, 9 und das dielektrische Element 11 einen Stapel, wobei - in Stapelrichtung gesehen - das dielektrische Element auf der ersten Elektrode 7 und die zweite Elektrode 9 auf dem dielektrischen Element 11 angeordnet sind.

Die erste Elektrode 7 weist - in Stapelrichtung gesehen - eine erste Dicke d₁ von mindestens 10 µm auf, wobei die zweite Elektrode 9 - ebenfalls in Stapelrichtung gesehen - eine zweite Dicke d₂ von mindestens 1 µm bis höchstens 5 µm, oder von mindestens 5 µm bis höchstens 30 µm aufweist. Das dielektrische Element weist - in Stapelrichtung gesehen - eine dritte Dicke d₃ von mindestens 10 µm bis höchstens 250 µm auf.

Die Elektrodenanordnung 5 ist somit als Dünnschicht-Elektrodenanordnung ausgebildet und weist insgesamt eine äußerst geringe Dicke auf. Sie ist dadurch insgesamt biegsam, sodass sie flexibel an eine Vielzahl möglicher Verwendungen und insbesondere an eine Vielzahl von geometrisch verschiedenen zu behandelnden Oberflächen angepasst werden kann. Weiterhin kann die Elektrodenanordnung 5 aufgrund ihrer sehr dünnen Ausgestaltung bei niedriger Spannung, insbesondere von weniger als 3 kVₚₚ, betrieben werden, was die elektrische Sicherheit der Plasmaanordnung 1 erhöht.

Die zweite Elektrode 9 weist auf einer dem dielektrischen Element 11 abgewandten Seite ein dielektrisches Deckelement 13 auf, das - in Stapelrichtung gesehen - eine vierte Dicke d₄ von mindestens 0,2 µm bis höchstens 30 µm aufweist. Das dielektrische Deckelement 13 ist bevorzugt als Beschichtung ausgebildet, wobei insbesondere die zweite Elektrode 9 mit dem dielektrischen Deckelement 13 beziehungsweise mit dem Material des dielektrischen Deckelements 13 beschichtet ist. Dabei bedeckt das dielektrische Deckelement 13 die zweite Elektrode 9 bevorzugt vollständig.

Die erste Elektrode 7 weist auf einer dem dielektrischen Element 11 abgewandten Seite ein dielektrisches Bodenelement 15 auf. Dieses ist vorzugsweise flächig ausgebildet und erstreckt sich entlang einer gesamten Erstreckung der ersten Elektrode 7, deckt diese also vollständig - in Figur 1 nach unten - ab. Dadurch verhindert das dielektrische Bodenelement 15 in sehr effizienter Weise Koronarentladungen, welche von der ersten Elektrode 7 ansonsten ausgehen könnten, sodass die Effizienz der Elektrodenanordnung 5 durch das dielektrische Bodenelement 15 erhöht wird. Eine fünfte Dicke d₅ des dielektrischen Bodenelements 15 ist bevorzugt so gewählt, dass einerseits von der ersten Elektrode 7 ausgehende Koronarentladungen sicher vermieden werden, wobei andererseits die Elektrodenanordnung 5 insgesamt biegsam ausgebildet ist.

Insgesamt ergibt sich also eine gestapelte Elektrodenanordnung 5 mit folgender Stapelfolge: Auf dem dielektrischen Bodenelement 15 ist die erste Elektrode 7 angeordnet, auf welcher das dielektrische Element 11 angeordnet ist. Auf diesem ist die zweite Elektrode 9 angeordnet, auf welcher das dielektrische Deckelement 13 angeordnet ist.

Die wenigstens eine erste Elektrode 7 und/oder die wenigstens eine zweite Elektrode 9 weist/weisen bevorzugt ein Material auf, welches ausgewählt ist aus einer Gruppe bestehend aus Kupfer, Silber, Gold und Aluminium. Vorzugsweise besteht wenigstens eine der ersten und zweiten Elektroden 7, 9 aus einem der genannten Materialien. Auch andere leitfähige Materialien sind für die Elektroden 7, 9 möglich, insbesondere auch Legierungen, besonders bevorzugt basierend auf wenigstens einem der genannten Elemente.

Das dielektrische Element 11, das dielektrische Deckelement 13 und/oder das dielektrische Bodenelement 15 weist/weisen bevorzugt ein Material auf, welches ausgewählt ist aus einer Gruppe bestehend aus Siliziumnitrid, einem Silikat, insbesondere Quarz, einem Glas, und einem Kunststoff, insbesondere Polyamid. Es ist auch möglich, dass wenigstens eines der genannten Elemente aus einem der genannten Materialien besteht. Auch andere anorganische oder organische Materialien sind für die genannten Elemente möglich, solange sie dielektrische und insbesondere elektrisch isolierende Eigenschaften aufweisen.

Die erste Elektrode 7 ist flächig ausgebildet, insbesondere als Schicht- oder Blattelektrode.

Die zweite Elektrode 9 ist vorzugsweise strukturiert ausgebildet. Insbesondere weist sie bei dem in Figur 1 dargestellten Ausführungsbeispiel eine Mehrzahl linienförmiger Teilelektroden 17 auf. Dabei kann die Struktur der zweiten Elektrode 9 insbesondere auf eine konkret gewünschte Anwendung der Elektrodenanordnung 5 abgestimmt sein.

Insbesondere das dielektrische Element 11 und/oder das dielektrische Deckelement 13 weisen bevorzugt eine mittlere Oberflächenrauheit R_{A} auf, die geringer ist als 5 % der Dicke des jeweiligen Elements. Alternativ oder zusätzlich weist bevorzugt das dielektrische Bodenelement 15 eine mittlere Oberflächenrauheit Rₐ auf, die geringer ist als 5 % seiner Dicke.

Die Spannungsquelle 3 ist insbesondere mit der ersten Elektrode 7 elektrisch verbunden, wobei die erste Elektrode 7 bevorzugt mit einer Wechselspannung beaufschlagbar ist. Die zweite Elektrode 9 ist bevorzugt auf Masse gelegt oder geerdet. Bei dem hier dargestellten Ausführungsbeispiel sind beide Elektroden 7, 9 über einen Verstärker 19 mit der Spannungsquelle 3 elektrisch verbunden. Der Verstärker 19 ist vorzugsweise als Piezo-Verstärker ausgebildet.

Die Elektrodenanordnung 5 wird vorzugsweise mit einer Wechselspannung betrieben, deren Amplitude von mindestens 0,5 kVₚₚ bis höchstens 3 kVₚₚ, vorzugsweise von mindestens 1,0 kVₚₚ bis höchstens 2,5 kVₚₚ, vorzugsweise von mindestens 1,0 kVₚₚ bis höchstens 2,0 kVₚₚ, vorzugsweise 1,5 kVₚₚ beträgt. Die Wechselspannung weist vorzugsweise eine Frequenz von mindestens 20 kHz bis höchstens 90 kHz, vorzugsweise mindestens 30 kHz bis höchstens 80 kHz, vorzugsweise mindestens 40 kHz bis höchstens 70 kHz, vorzugsweise mindestens 50 kHz bis höchstens 60 kHz, vorzugsweise 50 kHz auf.

Figur 2 zeigt eine Mehrzahl verschiedener Ausführungsbeispiele, die nicht Teil der Erfindung sind, der Elektrodenanordnung 5, wobei hier schematisch jeweils die erste, flächige Elektrode 7 und die strukturierte, zweite Elektrode 9 - in Draufsicht gesehen - dargestellt sind.

Dabei ist in Figur 2a) eine zweite Elektrode 9 dargestellt, welche eine kammartige Struktur mit einer Mehrzahl von parallel zueinander angeordneten, elektrisch miteinander verbundenen geraden Linien aufweist, die sich ausgehend von einem gemeinsamen Basiselement 21 in Figur 2a) nach rechts erstrecken.

In Figur 2b) weist die zweite Elektrode 9 ebenfalls eine kammartige Struktur auf, wobei sich allerdings ausgehend von dem Basiselement 21 schlangenlinienartige Teilelektroden parallel zueinander erstrecken. Die einzelnen Teilelektroden sind durch das gemeinsame Basiselement 21 elektrisch miteinander verbunden.

In Figur 2c) weist die zweite Elektrode 9 ebenfalls eine linienförmige Struktur auf, allerdings in Form einer als eckige Zickzacklinie verlaufenden Bahn.

In Figur 2d) weist die zweite Elektrode 9 die Form einer eckigen Spirale auf.

In Figur 2e) weist die zweite Elektrode 9 die Form einer runden Spirale, insbesondere einer Kreisspirale, auf.

Schließlich weist die zweite Elektrode 9 in Figur 2f) eine Mäanderstruktur auf.

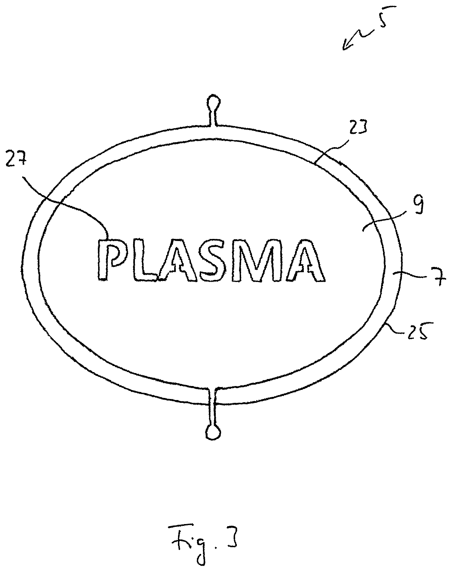

Figur 3 zeigt eine schematische Darstellung eines weiteren Ausführungsbeispiels der Elektrodenanordnung 5, insbesondere in Hinblick auf eine weitere mögliche Ausgestaltung der zweiten Elektrode 9. Gleiche und funktionsgleiche Elemente sind mit gleichen Bezugszeichen versehen, sodass insofern auf die vorangegangene Beschreibung verwiesen wird. Bei dem hier dargestellten Ausführungsbeispiel ist die erste Elektrode 7 in Blickrichtung des Betrachters gesehen, also senkrecht zur Bildebene von Figur 3, unter der zweiten Elektrode 9 angeordnet, wobei sie - senkrecht zur Blickrichtung des Betrachters, also in der Bildebene von Figur 3 - über eine erste äußere Umrandung 23 der zweiten Elektrode 9 übersteht, sodass also die erste Elektrode 7 mit einer zweiten äußeren Umrandung 25 die zweite Elektrode 9 seitlich überragt. Das dielektrische Element 11 ist in Figur 3 der besseren Übersichtlichkeit wegen nicht dargestellt. Es ist aber bei der Elektrodenanordnung 5 zwischen der ersten Elektrode 7 und der zweiten Elektrode 9 - in Stapelrichtung, das heißt senkrecht zur Bildebene von Figur 3 gesehen - angeordnet, wobei es vorzugsweise seitlich sowohl die erste Elektrode 9 mit ihrer ersten äußeren Umrandung 23 als auch die zweite äußere Umrandung 25 der ersten Elektrode 7 überragt.

Bei der hier dargestellten Konfiguration, insbesondere mit Blick auf die erste äußere Umrandung 23 der zweiten Elektrode 9 und die zweite äußere Umrandung 25 der ersten Elektrode 7, können Oberflächen-Mikroentladungen insbesondere auch im Bereich der ersten äußeren Umrandung 23 der zweiten Elektrode 9 gebildet werden. Überragt bei einem anderen Ausführungsbeispiel die erste äußere Umrandung 23 der zweiten Elektrode 9 seitlich die zweite äußere Umrandung 25 der ersten Elektrode 7, finden keine Oberflächen-Mikroentladungen an der ersten äußeren Umrandung 23 der zweiten Elektrode 9 statt.

Die zweite Elektrode 9 ist bei dem hier dargestellten Ausführungsbeispiel flächig ausgebildet und weist eine Mehrzahl von Ausnehmungen 27 auf, von denen der besseren Übersichtlichkeit wegen nur eine Ausnehmung mit dem Bezugszeichen 27 gekennzeichnet ist. Die Ausnehmungen 27 sind insbesondere als Durchbrüche in der Fläche der zweiten Elektrode 9 ausgebildet. Im Betrieb der Elektrodenanordnung 5 bilden sich dabei Oberflächen-Mikroentladungen insbesondere an Kanten der Ausnehmungen 27 aus.

Es zeigt sich, dass die Ausnehmungen 27 hier dem menschlichen Verstand zugängliche oder für den menschlichen Verstand verständliche Symbole bilden, nämlich Buchstaben, wobei die Ausnehmungen 27 insgesamt ein Wort bilden, nämlich das Wort "Plasma". In analoger Weise können mit derartigen Ausnehmungen 27 in der zweiten Elektrode 9 andere Worte, Zahlen, Kombinationen von Buchstaben und Zahlen, Piktogramme, Bilder, Gesichter, Logos und dergleichen gebildet werden.

Die Kanten der Ausnehmungen 27 weisen vorzugsweise voneinander einen Abstand auf, der mindestens 0,5 mm beträgt. Auf diese Weise können ungeschwächte Oberflächen-Mikroentladungen mit optimalem Wirkungsgrad an den Kanten der Ausnehmung 27 erzeugt werden.

Insgesamt zeigt sich, dass mittels der hier vorgeschlagenen Elektrodenanordnung 5, der Plasmaquelle 1 und dem Verfahren eine weitreichende Miniaturisierung bei hoher Designfreiheit für eine Vorrichtung zur Erzeugung eines nicht-thermischen Plasmas und/oder zur Plasmabehandlung, insbesondere von Oberflächen, möglich ist, wobei eine elektrische Sicherheit der Vorrichtung erhöht ist, und wobei ein Behandlungsabstand in weiten Bereichen stets passend zu einer für den konkreten Einsatz gewünschten Plasmachemie gewählt werden kann.

## Patentansprüche

1. Elektrodenanordnung (5) zur Erzeugung eines nicht-thermischen Plasmas, mit
- einer ersten Elektrode (7) und einer zweiten Elektrode (9), die
- durch ein dielektrisches Element (11) elektrisch voneinander isoliert und voneinander beabstandet sind,
wobei
- die erste Elektrode (7) - in Richtung der Beabstandung der Elektroden (7,9) voneinander gesehen - eine Dicke von mindestens 10 µm aufweist, wobei
- die zweite Elektrode (9) - in Richtung der Beabstandung der Elektroden (7,9) voneinander gesehen - eine Dicke von mindestens 1 µm bis höchstens 5 µm oder eine Dicke von mindestens 5 µm bis höchstens 30 µm aufweist, wobei
- das dielektrische Element (11) eine Dicke von mindestens 10 µm bis höchstens 250 µm aufweist, und wobei
- die erste Elektrode (7) und die zweite Elektrode (9) übereinander - das heißt auf zwei zueinander versetzten Ebenen - angeordnet und durch das dielektrische Element (11) voneinander beabstandet sind, **dadurch gekennzeichnet, dass**
- die erste Elektrode (7) flächig als Blatt- oder Schichtelektrode ohne Ausnehmung ausgebildet ist, und wobei
- die zweite Elektrode (9) flächig ausgebildet ist und wenigstens eine Ausnehmung (27) aufweist.

2. Elektrodenanordnung (5) nach Anspruch 1, wobei
a) die zweite Elektrode eine Dicke von mindestens 5 µm bis höchstens 30 µm aufweist, und/oder dass
b) die zweite Elektrode (9) auf einer dem dielektrischen Element (11) abgewandten Seite ein dielektrisches Deckelement (13) aufweist, das - in Richtung der Beabstandung der Elektroden (7,9) voneinander gesehen - eine Dicke von mindestens 0,2 µm bis höchstens 30 µm aufweist.

3. Elektrodenanordnung (5) nach einem der vorhergehenden Ansprüche, wobei die erste Elektrode (7) auf einer dem dielektrischen Element (11) abgewandten Seite ein dielektrisches Bodenelement (15) aufweist.

4. Elektrodenanordnung (5) nach einem der vorhergehenden Ansprüche, wobei wenigstens eine Elektrode, ausgewählt aus der ersten Elektrode (7) und der zweiten Elektrode (9), ein Material aufweist oder aus einem Material besteht, das ausgewählt ist aus einer Gruppe bestehend aus Kupfer, Silber, Gold und Aluminium.

5. Elektrodenanordnung (5) nach einem der vorhergehenden Ansprüche, wobei wenigstens ein Element, ausgewählt aus dem dielektrischen Element (11), dem dielektrischen Deckelement (13) und dem dielektrischen Bodenelement (15), ein Material aufweist oder aus einem Material besteht, das ausgewählt ist aus einer Gruppe bestehend aus Siliziumnitrid, einem Silikat, insbesondere Quarz, einem Glas, und einem Kunststoff, insbesondere Polyamid.

6. Elektrodenanordnung (5) nach einem der vorhergehenden Ansprüche, wobei wenigstens ein Element ausgewählt aus dem dielektrischen Element (11) und dem dielektrischen Deckelement (13), eine mittlere Oberflächenrauheit (Rₐ) aufweist, die kleiner ist als 5 % der Dicke des Elements.

7. Plasmaquelle (1) zur Erzeugung eines nicht-thermischen Plasmas, mit einer Spannungsquelle (3) und mit einer Elektrodenanordnung (5) nach einem der Ansprüche 1 bis 6, wobei die Spannungsquelle (3) zumindest mit der ersten Elektrode (7) elektrisch verbunden ist.

8. Plasmaquelle (1) nach Anspruch 7, wobei die erste Elektrode (7) mit einer Wechselspannung beaufschlagbar ist, wobei die zweite Elektrode (9) auf Masse gelegt oder geerdet ist.

9. Plasmaquelle (1) nach einem der Ansprüche 7 und 8, wobei die Plasmaquelle (1) eingerichtet ist zur Erzeugung von Wechselspannung mit einer Amplitude von mindestens 0,5 kVₚₚ bis höchstens 3 kVₚₚ, vorzugsweise von mindestens 1,0 kVₚₚ bis höchstens 2,5 kVₚₚ, vorzugsweise von mindestens 1,0 kVₚₚ bis höchstens 2,0 kVₚₚ, vorzugsweise von 1,5 kVₚₚ, und/oder bei einer Frequenz von mindestens 20 kHz bis höchstens 90 kHz, vorzugsweise von mindestens 30 kHz bis höchstens 80 kHz, vorzugsweise von mindestens 40 kHz bis höchstens 70 kHz, vorzugsweise von mindestens 50 kHz bis höchstens 60 kHz, vorzugsweise von 50 kHz.

10. Plasmaquelle (1) nach einem der Ansprüche 7 bis 9, wobei die Plasmaquelle (1) einen Piezo-Verstärker (19) aufweist.

11. Verfahren zum Betreiben einer Plasmaquelle (1), wobei eine Elektrodenanordnung (5) nach einem der Ansprüche 1 bis 6 mittels einer Spannungsquelle (3) mit elektrischer Spannung beaufschlagt wird, und/oder wobei eine Plasmaquelle (1) nach einem der Ansprüche 7 bis 10 betrieben wird.

12. Verfahren nach Anspruch 11, wobei die Plasmaquelle (1) mit einer Wechselspannung mit einer Amplitude von mindestens 0,5 kVₚₚ bis höchstens 3 kVₚₚ, vorzugsweise von mindestens 1,0 kVₚₚ bis höchstens 2,5 kVₚₚ, vorzugsweise von mindestens 1,0 kVₚₚ bis höchstens 2,0 kVₚₚ, vorzugsweise von 1,5 kVₚₚ betrieben wird.

13. Verfahren nach einem der Ansprüche 11 und 12, wobei die Plasmaquelle (1) mit einer Wechselspannung mit einer Frequenz von mindestens 20 kHz bis höchstens 90 kHz, vorzugsweise von mindestens 30 kHz bis höchstens 80 kHz, vorzugsweise von mindestens 40 kHz bis höchstens 70 kHz, vorzugsweise von mindestens 50 kHz bis höchstens 60 kHz, vorzugsweise mit 50 kHz, betrieben wird.

## Claims

1. Electrode arrangement (5) for generating a nonthermal plasma, with:
- a first electrode (7) and a second electrode (9) that
- are electrically insulated from each other and spaced from each other by a dielectric element (11), wherein
- the first electrode (7) - viewed in the direction of the spacing of the electrodes (7, 9) from each other - has a thickness of at least 10 µm, wherein
- the second electrode (9) - viewed in the direction of the spacing of the electrodes (7, 9) from each other - has a thickness of at least 1 µm to at most 5 µm or a thickness of at least 5 µm to at most 30 µm, wherein
- the dielectric element (11) has a thickness of at least 10 µm to at most 250 µm, and wherein
- the first electrode (7) and the second electrode (9) are arranged superimposed - i.e., on two planes offset from each other - and are spaced from each other by the dielectric element (11)
**characterized in that**
- the first electrode (7) is configured flat as a layer electrode or leaf electrode without a recess, and wherein
- the second electrode (9) is configured flat and comprises at least one recess (27).

2. Electrode arrangement (5) according to claim 1, wherein
a) the second electrode has a thickness of at least 5 µm to at most 30 µm, and/or that
b) the second electrode (9) comprises a dielectric cover element (13) on a side facing away from the dielectric element (11) that - viewed in the direction of the spacing of the electrodes (7, 9) - has a thickness of at least 0.2 µm to at most 30 µm.

3. Electrode arrangement (5) according to any of the preceding claims, wherein the first electrode (7) comprises a dielectric base element (15) on the side facing away from the dielectric element (11).

4. Electrode arrangement (5) according to any of the preceding claims, wherein at least one electrode, selected from the first electrode (7) and the second electrode (9), comprises a material or consists of a material that is selected from a group consisting of copper, silver, gold and aluminium.

5. Electrode arrangement (5) according to any of the preceding claims, wherein at least one element, selected from the dielectric element (11), the dielectric cover element (13) and the dielectric base element (15), comprises a material or consists of a material that is selected from the group consisting of silicon nitride, a silicate, in particular quartz, a glass and a plastic, in particular polyamide.

6. Electrode arrangement (5) according to any of the preceding claims, wherein at least one element, selected from the dielectric element (11) and the dielectric cover element (13), has an average surface roughness (Rₐ) that is less than 5% of the thickness of the element.

7. Plasma source (1) for generating a nonthermal plasma with a voltage source (3) and an electrode arrangement (5) according to any of claims 1 to 6, wherein the voltage source (3) is electrically connected at least to the first electrode (7).

8. Plasma source according to claim 7, wherein an AC voltage can be applied to the first electrode (7), wherein the second electrode is earthed or grounded.

9. Plasma source according to any of claims 7 and 8, wherein the plasma source (1) is set up to generate AC voltage with an amplitude of at least 0.5 kVₚₚ, to at most 3 kVₚₚ, preferably of at least 1.0 kVₚₚ to at most 2.5 kVₚₚ, preferably of at least 1.0 kVₚₚ to at most 2.0 kVₚₚ, preferably of 1.5 kVₚₚ, and/or at a frequency of at least 20 kHz to at most 90 kHz, preferaly of at least 30 kHz to at most 80 kHz, preferably of at least 40 kHz to at most 70 kHz, preferably of at least 50 kHz to at most 60 kHz, preferably of 50 kHz.

10. Plasma source (1) according to any of claims 7 to 9, wherein the plasma source (1) comprises a piezoamplifier (19).

11. Method for operating a plasma source (1), wherein electrical voltage is applied to an electrode arrangement (5) according to any of claims 1 to 6 by means of a voltage source (3) and/or wherein a plasma source (1) according to any of claims 7 to 10 is operated.

12. Method according to claim 11, wherein the plasma source (1) is operated with an AC voltage with an amplitude of at least 0.5 kVₚₚ to at most 3 kVₚₚ, preferably of at least 1.0 kVₚₚ to at most 2.5 kVₚₚ, preferably of at least 1.0 kVₚₚ to at most 2.0 kVₚₚ, preferably of 1.5 kVₚₚ.

13. Method according to any of claims 11 and 12, wherein the plasma source is operated with an AC voltage at a frequency of at least 20 kHz to at most 90 kHz, preferably of at least 30 kHz to at most 80 kHz, preferably of at least 40 kHz to at most 70 kHz, preferably of at least 50 kHz to at most 60 kHz, preferably of 50 kHz.

## Revendications

1. Ensemble d'électrodes (5) pour la production d'un plasma non thermique, comprenant
- une première électrode (7) et une deuxième électrode (9), qui
- par un élément diélectrique (11), sont électriquement isolées l'une de l'autre et sont espacées l'une de l'autre, dans lequel
- la première électrode (7) - vue dans le sens de l'écartement des électrodes (7, 9) l'une de l'autre - présente une épaisseur d'au moins 10 µm, dans lequel
- la deuxième électrode (9) - vue dans le sens de l'écartement des électrodes (7, 9) l'une de l'autre - présente une épaisseur d'au moins 1 µm à au plus 5 µm ou une épaisseur d'au moins 5 µm à au plus 30 µm, dans lequel
- l'élément diélectrique (11) présente une épaisseur d'au moins 10 µm et à au plus 250 µm, et dans lequel
- la première électrode (7) et la deuxième électrode (9) sont disposées l'une au-dessus de l'autre - c'est-à-dire sur deux plans décalés l'un par rapport à l'autre - et sont espacées l'une de l'autre par l'élément diélectrique (11),
**caractérisé en ce que**
- la première électrode (7) est réalisée à plat sous forme d'électrode en feuille ou en couche sans évidement, et dans lequel
- la deuxième électrode (9) est réalisée à plat et présente au moins un évidement (27).

2. Ensemble d'électrodes (5) selon la revendication 1, dans lequel
a) la deuxième électrode présente une épaisseur d'au moins 5 µm à au plus 30 µm, et/ou
b) la deuxième électrode (9) présente, sur un côté opposé à l'élément diélectrique (11), un élément de recouvrement diélectrique (13) qui - vu dans le sens de l'écartement des électrodes (7, 9) l'une de l'autre - présente une épaisseur d'au moins 0,2 µm à au plus 30 µm.

3. Ensemble d'électrodes (5) selon l'une quelconque des revendications précédentes, dans lequel la première électrode (7) présente un élément de fond diélectrique (15) sur un côté opposé à l'élément diélectrique (11).

4. Ensemble d'électrodes (5) selon l'une quelconque des revendications précédentes, dans lequel au moins une électrode choisie parmi la première électrode (7) et la seconde électrode (9) présente un matériau ou est constituée d'un matériau choisi dans un groupe constitué par le cuivre, l'argent, l'or et l'aluminium.

5. Ensemble d'électrodes (5) selon l'une quelconque des revendications précédentes, dans lequel au moins un élément choisi parmi l'élément diélectrique (11), l'élément de recouvrement diélectrique (13) et l'élément de fond diélectrique (15) présente un matériau, ou est constitué d'un matériau, choisi dans un groupe constitué par le nitrure de silicium, un silicate, en particulier le quartz, un verre, et une matière plastique, en particulier le polyamide.

6. Ensemble d'électrodes (5) selon l'une quelconque des revendications précédentes, dans lequel au moins un élément choisi parmi l'élément diélectrique (11) et l'élément de recouvrement diélectrique (13), présente une rugosité de surface moyenne (Rₐ) qui est inférieure à 5 % de l'épaisseur de l'élément.

7. Source de plasma (1) pour la production d'un plasma non thermique, avec une source de tension (3) et avec un ensemble d'électrodes (5) selon l'une des revendications 1 à 6, dans laquelle la source de tension (3) est reliée électriquement au moins à la première électrode (7).

8. Source de plasma (1) selon la revendication 7, dans laquelle la première électrode (7) peut être alimentée par une tension alternative, la deuxième électrode (9) étant mise à la masse ou à la terre.

9. Source de plasma (1) selon l'une des revendications 7 et 8, dans laquelle la source de plasma (1) est adaptée pour générer une tension alternative avec une amplitude d'au moins 0,5 kVₚₚ à au plus 3 kVₚₚ, de préférence d'au moins 1,0 kVₚₚ à au plus 2,5 kVₚₚ, de préférence d'au moins 1,0 kVₚₚ à au plus 2,0 kVₚₚ, de préférence de 1,5 kVₚₚ, et/ou à une fréquence d'au moins 20 kHz à au plus 90 kHz, de préférence d'au moins 30 kHz à au plus 80 kHz, de préférence d'au moins 40 kHz à au plus 70 kHz, de préférence d'au moins 50 kHz à au plus 60 kHz, de préférence de 50 kHz.

10. Source de plasma (1) selon l'une quelconque des revendications 7 à 9, dans laquelle la source de plasma (1) présente un amplificateur piézoélectrique (19).

11. Procédé pour faire fonctionner une source de plasma (1), dans lequel un ensemble d'électrodes (5) selon l'une des revendications 1 à 6 est alimenté en tension électrique au moyen d'une source de tension (3), et/ou dans lequel on fait fonctionner une source de plasma (1) selon l'une des revendications 7 à 10.

12. Procédé selon la revendication 11, dans lequel la source de plasma (1) fonctionne avec une tension alternative ayant une amplitude d'au moins 0,5 kVₚₚ à au plus 3 kVₚₚ, de préférence d'au moins 1,0 kVₚₚ à au plus 2,5 kVₚₚ, de préférence d'au moins 1,0 kVₚₚ à au plus 2,0 kVₚₚ, de préférence de 1,5 kVₚₚ.

13. Procédé selon l'une quelconque des revendications 11 et 12, dans lequel la source de plasma (1) fonctionne avec une tension alternative ayant une fréquence d'au moins 20 kHz à au plus 90 kHz, de préférence d'au moins 30 kHz à au plus 80 kHz, de préférence d'au moins 40 kHz à au plus 70 kHz, de préférence d'au moins 50 kHz à au plus 60 kHz, de préférence de 50 kHz.
